# EUROPEAN PATENT APPLICATION

(11) **EP 4 823 294 A1**
(43) Date of publication of application: **14.10.2026**
(21) Application number: 24916026.8
(22) Date of filing: 11.01.2024
(51) Int. Cl.: H10K 59/122, H10K 59/12

(54) **DISPLAY SUBSTRATE AND MANUFACTURING METHOD THEREFOR**

(71) Applicant: BOE Technology Group Co., Ltd., Beijing 100015 (CN); Beijing BOE Technology Development Co., Ltd., Daxing District Beijing 100176 (CN)
(72) Inventor: LI, Liuqing, Beijing 100176 (CN); LI, Xiaohu, Beijing 100176 (CN); LIU, Xiaoyun, Beijing 100176 (CN); CAO, Zhanfeng, Beijing 100176 (CN); YUAN, Guangcai, Beijing 100176 (CN); WANG, Hongli, Beijing 100176 (CN)
(74) Representative: Brötz, Helmut
(86) International application number: PCT/CN2024/071779
(87) International publication number: WO 2025/147950

(57) **Abstract**

A display substrate and a manufacturing method therefor. The display substrate comprises a base substrate (110), a driving circuit layer (120), a plurality of first electrodes (E1), and a pixel defining layer (PDL); the driving circuit layer (120) is provided on the base substrate (110) and comprises a plurality of pixel driving circuits (D) for a plurality of subpixels (SP) and a protective insulating layer (PLN) covering the plurality of pixel driving circuits (D); the plurality of first electrodes (E1) are provided on the side of the driving circuit layer (120) distant from the base substrate (110), and are respectively electrically connected to output terminals (T) of the plurality of pixel driving circuits (D) through a plurality of first via holes (PLN1) of the protective insulating layer (PLN); the pixel defining layer (PDL) is at least provided on the side of the plurality of first electrodes (E1) distant from the base substrate (110), and comprises a plurality of first openings (O1) respectively exposing the plurality of first electrodes (E1) and a plurality of second openings (O2) formed between adjacent subpixels (SP) among the plurality of subpixels (SP); and the pixel defining layer (PDL) has first partition structures (P1) at the plurality of first openings (O1) and has second partition structures (P2) at the plurality of second openings (O2). The display substrate has a high color gamut and a good display effect.

## Description

### TECHNICAL FIELD

Embodiments of the present disclosure relate to a display substrate and a method for manufacturing a display substrate.

### BACKGROUND

Organic Light Emitting Diode (OLED) display devices have a series of advantages such as self-luminescence, high contrast, high clarity, wide viewing angle, low power consumption, fast response speed, and low manufacturing cost, and have become one of the key development directions for the new generation of display devices, and therefore have attracted increasing attention.

### SUMMARY

At least one embodiment of the present disclosure provides a display substrate, the display substrate has a plurality of sub-pixels arranged in an array, and comprises a base substrate, a driving circuit layer, a plurality of first electrodes, and a pixel definition layer; the driving circuit layer is provided on the base substrate, and comprises a plurality of pixel driving circuits for the plurality of sub-pixels and a protective insulation layer covering the plurality of pixel driving circuits, in which the protective insulation layer comprises a plurality of first vias exposing output terminals of the plurality of pixel driving circuits; the plurality of first electrodes are provided on a side of the driving circuit layer away from the base substrate, and electrically connected to the output terminals of the plurality of pixel driving circuits through the plurality of first vias, respectively; the pixel definition layer is at least provided on a side of the plurality of first electrodes away from the base substrate, and comprises a plurality of first openings respectively exposing the plurality of first electrodes and a plurality of second openings provided between adjacent sub-pixels among the plurality of sub-pixels, in which the pixel definition layer comprises a first partition structure at the plurality of first openings and a second partition structure at the plurality of second openings.

For example, in the display substrate provided by at least one embodiment of the present disclosure, in a direction perpendicular to the base substrate, a height of the first partition structure is different from a height of the second partition structure.

For example, in the display substrate provided by at least one embodiment of the present disclosure, the height of the first partition structure is less than the height of the second partition structure.

For example, in the display substrate provided by at least one embodiment of the present disclosure, the pixel definition layer comprises a first pixel definition layer and a second pixel definition layer provided on a side of the first pixel definition layer away from the base substrate; and the first pixel definition layer comprises an inorganic material, and the second pixel definition layer comprises an organic material.

For example, in the display substrate provided by at least one embodiment of the present disclosure, the organic material comprises polyimide or resin.

For example, in the display substrate provided by at least one embodiment of the present disclosure, the first pixel definition layer comprises a first sub-pixel definition layer and a second sub-pixel definition layer provided on a side of the first sub-pixel definition layer away from the base substrate, and a material of the first sub-pixel definition layer is different from a material of the second sub-pixel definition layer; and in a direction parallel to the base substrate, and at the plurality of first openings, the first sub-pixel definition layer is recessed relative to the second sub-pixel definition layer, such that the first partition structure comprises a first undercut structure.

For example, in the display substrate provided by at least one embodiment of the present disclosure, at the plurality of first openings, the first sub-pixel definition layer is recessed relative to the second sub-pixel definition layer by a distance of 0.05 µm to 0.2 µm.

For example, in the display substrate provided by at least one embodiment of the present disclosure, the first pixel definition layer comprises a first sub-pixel definition layer and a second sub-pixel definition layer provided on a side of the first sub-pixel definition layer away from the base substrate, and a material of the first sub-pixel definition layer is different from a material of the second sub-pixel definition layer; and in a direction parallel to the base substrate, and at the plurality of second openings, the first sub-pixel definition layer is recessed relative to the second sub-pixel definition layer, such that the second partition structure comprises a second undercut structure.

For example, in the display substrate provided by at least one embodiment of the present disclosure, at the plurality of second openings, the first sub-pixel definition layer is recessed relative to the second sub-pixel definition layer by a distance of 0.05 µm to 0.2 µm.

For example, in the display substrate provided by at least one embodiment of the present disclosure, two materials selected from a group consisting of Al₂O₃, SiN, SiO, SiCN, TiO, and Nb₂O₅ are respectively materials of the first sub-pixel definition layer and the second sub-pixel definition layer.

For example, in the display substrate provided by at least one embodiment of the present disclosure, in a direction perpendicular to the base substrate, a thickness of the first sub-pixel definition layer is greater than a thickness of the second sub-pixel definition layer.

For example, in the display substrate provided by at least one embodiment of the present disclosure, the thickness of the first sub-pixel definition layer ranges from 25 nm to 50 nm, and the thickness of the second sub-pixel definition layer ranges from 20 nm to 25 nm.

For example, in the display substrate provided by at least one embodiment of the present disclosure, in a direction perpendicular to the base substrate, a thickness of the second pixel definition layer ranges from 0.8 µm to 1.5 µm.

For example, in the display substrate provided by at least one embodiment of the present disclosure, the second pixel definition layer comprises a first slope angle at each of the plurality of first openings and a second slope angle at each of the plurality of second openings; and the first slope angle ranges from 30° to 70°, and the second slope angle ranges from 30° to 70°.

For example, the display substrate provided by at least one embodiment of the present disclosure further comprises a passivation layer provided between the protective insulation layer and the plurality of first electrodes, the passivation layer comprises a plurality of second vias respectively exposing the plurality of first vias, and the plurality of first electrodes are electrically connected to the output terminals of the plurality of pixel driving circuits through the plurality of second vias and the plurality of first vias; and the passivation layer comprises a plurality of third openings respectively connected to the plurality of second openings, and orthographic projections of the plurality of third openings on the base substrate at least partially overlap with orthographic projections of the plurality of second openings on the base substrate.

For example, in the display substrate provided by at least one embodiment of the present disclosure, orthographic projections of the plurality of second vias on the base substrate are respectively located within orthographic projections of the plurality of first vias on the base substrate.

For example, in the display substrate provided by at least one embodiment of the present disclosure, the passivation layer comprises a first passivation layer and a second passivation layer provided on a side of the first passivation layer away from the base substrate; and materials of the first passivation layer and the second passivation layer are different, and the second passivation layer comprises the plurality of third openings.

For example, in the display substrate provided by at least one embodiment of the present disclosure, in a direction perpendicular to the base substrate, a thickness of the first passivation layer is greater than a thickness of the second passivation layer.

For example, in the display substrate provided by at least one embodiment of the present disclosure, the thickness of the first passivation layer ranges 100 nm to 200 nm, and the thickness of the second passivation layer ranges 40 nm to 100 nm.

For example, in the display substrate provided by at least one embodiment of the present disclosure, the protective insulation layer comprises a plurality of fourth openings respectively connected to the plurality of second openings, and orthographic projections of the plurality of fourth openings on the base substrate at least partially overlap with orthographic projections of the plurality of second openings on the base substrate.

For example, in the display substrate provided by at least one embodiment of the present disclosure, in a direction parallel to the base substrate, the plurality of fourth openings respectively extend outward relative to the plurality of second openings, such that the orthographic projections of the plurality of second openings on the base substrate are respectively located within the orthographic projections of the plurality of fourth openings on the base substrate.

For example, in the display substrate provided by at least one embodiment of the present disclosure, in the direction parallel to the base substrate, the plurality of fourth openings extend outward relative to the plurality of second openings by a distance of 0.1 µm to 0.5 µm.

For example, in the display substrate provided by at least one embodiment of the present disclosure, at least one second opening is provided between every two adjacent sub-pixels among the plurality of sub-pixels.

For example, in the display substrate provided by at least one embodiment of the present disclosure, at least part of the plurality of second openings are interconnected to form an annular opening that completely surrounds at least one of the plurality of sub-pixels.

For example, in the display substrate provided by at least one embodiment of the present disclosure, the plurality of second openings are respectively strip-shaped and spaced apart from each other.

For example, the display substrate provided by at least one embodiment of the present disclosure further comprises a light-emitting material layer and a second electrode layer; the light-emitting material layer is provided on a side of the pixel definition layer away from the base substrate; and the second electrode layer is provided on a side of the light-emitting material layer away from the base substrate, at least part of the light-emitting material layer is disconnected by at least one of the first partition structure and the second partition structure, and the second electrode layer is continuous at at least one of the first partition structure and the second partition structure.

For example, in the display substrate provided by at least one embodiment of the present disclosure, the light-emitting material layer comprises at least one charge generation layer, and the at least one charge generation layer is disconnected by at least one of the first partition structure and the second partition structure.

At least one embodiment of the present disclosure further provides a method for manufacturing a display substrate, the display substrate has a plurality of sub-pixels arranged in an array, and the method comprises: providing a base substrate; forming a driving circuit layer on the base substrate, in which the driving circuit layer comprises a plurality of pixel driving circuits for the plurality of sub-pixels and a protective insulation layer covering the plurality of pixel driving circuits, and the protective insulation layer comprises a plurality of first vias exposing output terminals of the plurality of pixel driving circuits; forming a plurality of first electrodes on a side of the driving circuit layer away from the base substrate, in which the plurality of first electrodes are electrically connected to the output terminals of the plurality of pixel driving circuits through the plurality of first vias, respectively; and forming a pixel definition layer at least on a side of the plurality of first electrodes away from the base substrate, in which the pixel definition layer comprises a plurality of first openings respectively exposing the plurality of first electrodes and a plurality of second openings provided between adjacent sub-pixels among the plurality of sub-pixels, and the pixel definition layer comprises a first partition structure formed at the plurality of first openings and a second partition structure formed at the plurality of second openings.

### BRIEF DESCRIPTION OF DRAWINGS

In order to clearly illustrate technical solutions of the embodiments of the present disclosure, the drawings of the embodiments will be briefly described. It is obvious that the described drawings in the following are only related to some embodiments of the present disclosure and thus are not construed as any limitation to the present disclosure.
Fig. 1 is a schematic plan view of a display substrate provided by at least one embodiment of the present disclosure;
Fig. 2 is a schematic partial cross-sectional view of the display substrate in Fig. 1 along a line A-A;
Fig. 3 is a schematic cross-sectional view of a light-emitting device of a display substrate provided by at least one embodiment of the present disclosure;
Fig. 4A-Fig. 4B are transmission electron microscope images of a display substrate at a second partition structure provided by at least one embodiment of the present disclosure;
Fig. 4C is a transmission electron microscope image of a display substrate at a first partition structure provided by at least one embodiment of the present disclosure;
Fig. 5 is another schematic partial cross-sectional view of the display substrate in Fig. 1 along the line A-A;
Fig. 6 is yet another schematic partial cross-sectional view of the display substrate in Fig. 1 along the line A-A;
Fig. 7 is still another schematic partial cross-sectional view of the display substrate in Fig. 1 along the line A-A;
Fig. 8 is still another schematic partial cross-sectional view of the display substrate in Fig. 1 along the line A-A;
Fig. 9 is still another schematic partial cross-sectional view of the display substrate in Fig. 1 along the line A-A;
Fig. 10 is a planar scanning electron microscope image of a display substrate provided by at least one embodiment of the present disclosure;
Fig. 11-Fig. 13 are schematic views of different arrangements of first openings and second openings in a display substrate provided by at least one embodiment of the present disclosure;
Fig. 14 is a schematic partial cross-sectional view of the display substrate in Fig. 2 in a manufacturing process;
Fig. 15 is a schematic partial cross-sectional view of the display substrate in Fig. 6 in a manufacturing process;
Fig. 16 is a schematic partial cross-sectional view of the display substrate in Fig. 7 in a manufacturing process; and
Fig. 17 is a schematic partial cross-sectional view of the display substrate in Fig. 8 in a manufacturing process.

### DETAILED DESCRIPTION

In order to make objectives, technical details, and advantages of the embodiments of the present disclosure clearer, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

In an OLED display device, in order to increase the light emitting brightness of the OLED device, a charge generation layer (CGL) is introduced into a light-emitting material layer of the OLED device to connect a plurality of light-emitting layers in series. However, the charge generation layer is a high-mobility layer that functions to transfer electrons and holes to adjacent light-emitting layers. Due to the presence of the CGL, there may be lateral current transferring between adjacent sub-pixels, making the sub-pixel that should not emit light emit light, thereby reducing the color gamut of the display device.

At least one embodiment of the present disclosure provides a display substrate and a method for manufacturing the display substrate, the display substrate has a plurality of sub-pixels arranged in an array, and includes a base substrate, a driving circuit layer, a plurality of first electrodes, and a pixel definition layer. The driving circuit layer is provided on the base substrate, and includes a plurality of pixel driving circuits for the plurality of sub-pixels and a protective insulation layer covering the plurality of pixel driving circuits; the protective insulation layer includes a plurality of first vias exposing output terminals of the plurality of pixel driving circuits. The plurality of first electrodes are provided on a side of the driving circuit layer away from the base substrate, and electrically connected to the output terminals of the plurality of pixel driving circuits through the plurality of first vias, respectively. The pixel definition layer is at least provided on a side of the plurality of first electrodes away from the base substrate, and includes a plurality of first openings respectively exposing the plurality of first electrodes and a plurality of second openings provided between adjacent sub-pixels among the plurality of sub-pixels; and the pixel definition layer includes a first partition structure at the plurality of first openings and a second partition structure at the plurality of second openings.

In the display substrate provided by the embodiments of the present disclosure, by respectively providing a first partition structure and a second partition structure at different positions of the pixel definition layer, the partitioning effect on the light-emitting material layer can be fully realized within each sub-pixel and between adjacent sub-pixels. This effectively prevents electrical crosstalk between different sub-pixels and improves the color gamut of the display substrate.

The following specific embodiments will further illustrate a display substrate and a method for manufacturing the display substrate according to some embodiments of the present disclosure.

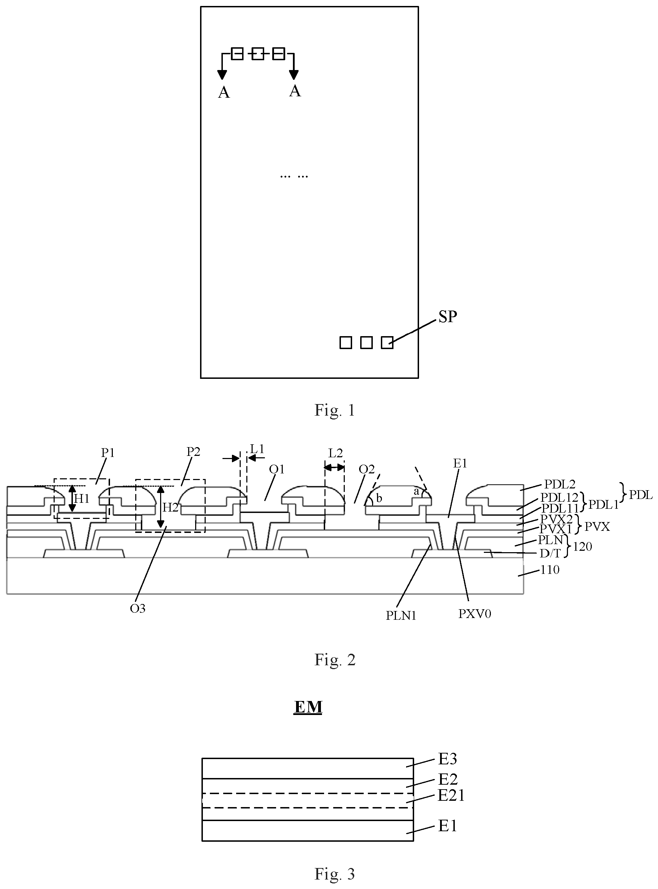

At least one embodiment of the present disclosure provides a display substrate. Fig. 1 illustrates a schematic plan view of the display substrate, Fig. 2 illustrates a schematic partial cross-sectional view of the display substrate in Fig. 1 along a line A-A, and Fig. 3 illustrates a schematic cross-sectional view of a light-emitting device. As shown in Fig. 1 and Fig. 2, the display substrate includes a plurality of sub-pixels SP arranged in an array, and includes a base substrate 110, a driving circuit layer 120, a plurality of first electrodes E1, and a pixel definition layer PDL.

As shown in Fig. 2, the driving circuit layer 120 is provided on the base substrate 110 and includes a plurality of pixel driving circuits D for the plurality of sub-pixels SP and a protective insulation layer PLN covering the plurality of pixel driving circuits D. For example, each sub-pixel SP includes one pixel driving circuit D and one light-emitting device EM, and the pixel driving circuit D is configured to drive the light-emitting device EM to emit light. For example, each pixel driving circuit D includes a plurality of thin-film transistors and one or more storage capacitors, to form, for example, a 2T1C structure (i.e., including two thin-film transistors and one storage capacitor), a 3T1C structure (i.e., including three thin-film transistors and one storage capacitor), a 7T1C structure (i.e., including seven thin-film transistors and one storage capacitor), an 8T2C structure (i.e., including eight thin-film transistors and two storage capacitors), or the like. The specific form of the pixel driving circuit D is not limited by the embodiments of the present disclosure.

For example, the protective insulation layer PLN may be an organic planarization layer, including an organic insulation material such as polyimide or resin. The protective insulation layer PLN is provided above the plurality of pixel driving circuits D to provide protection and planarization for the plurality of pixel driving circuits D.

For example, each pixel driving circuit D has an output terminal T to be connected to the light-emitting device EM to drive the light-emitting device EM. For example, as shown in Fig. 3, each light-emitting device EM includes a first electrode E1, a light-emitting material layer E2, and a second electrode layer E3 sequentially arranged in a direction away from the base substrate 110. The protective insulation layer PLN includes a plurality of first vias PLN1 exposing the output terminals T of the plurality of pixel driving circuits D. The plurality of first electrodes E1 are provided on a side of the driving circuit layer 120 away from the base substrate 110 and are electrically connected to the output terminals T of the plurality of pixel driving circuits D through the plurality of first vias PLN1. This configuration realizes the connection between the light-emitting device EM and the pixel driving circuit D in each sub-pixel SP.

As shown in Fig. 2, the pixel definition layer PDL is at least provided on a side of the plurality of first electrodes E1 away from the base substrate 110, and includes a plurality of first openings O1 respectively exposing the plurality of first electrodes E1 and a plurality of second openings O2 provided between adjacent sub-pixels SP among the plurality of sub-pixels SP. The plurality of first openings O1 may be served as sub-pixel openings to define the formation position of the light-emitting devices EM. The pixel definition layer PDL includes a first partition structure P1 at the plurality of first openings O1 and a second partition structure P2 at the plurality of second openings O2.

For example, in the embodiments of the present disclosure, the light-emitting material layer E2 is provided on a side of the pixel definition layer PDL away from the base substrate 110, and the second electrode layer E3 is provided on a side of the light-emitting material layer E2 away from the base substrate 110. For example, the first electrode E1 is served as an anode of the light-emitting device EL, and the second electrode layer E3 is served as a cathode of the light-emitting device EL. For example, generally, the second electrode layer E3 is continuously provided on the display substrate, that is, the second electrode layer E3 of the plurality of sub-pixels SP is provided continuously. This continuous configuration can reduce the resistance of the second electrode layer E3, ensuring that the electrical signals received by the second electrode layer E3 of the plurality of sub-pixels SP are substantially the same.

In the embodiments of the present disclosure, the first partition structure P1 and the second partition structure P2 can function to partition the light-emitting material layer E2 of the light-emitting device EM. For example, at least part of the light-emitting material layer E2 is disconnected by at least one of the first partition structure P1 and the second partition structure P2, that is, the light-emitting material layer E2 is discontinuous at the at least one of the first partition structure P1 and the second partition structure P2, while the second electrode layer E3 remains continuous at at least one of the first partition structure P1 and the second partition structure P2, which effectively prevents electrical crosstalk between different sub-pixels, thereby improving the color gamut of the display substrate.

For example, in some examples, the light-emitting material layer E2 includes at least one charge generation layer E21, the charge generation layer E21 has a high electron mobility. The charge generation layer E21 is disconnected by at least one of the first partition structure P1 and the second partition structure P2, thereby achieving the effect of preventing crosstalk between adjacent sub-pixels SP. For example, the light-emitting material layer E2 may also include functional layers such as an organic light-emitting layer, a hole injection layer, a hole transport layer, an electron blocking layer, an electron transport layer, and the like, which are not specifically limited in the embodiments of the present disclosure.

For example, the plurality of sub-pixels SP may include sub-pixels of three colors: red, green, and blue. The first partition structure P1 and the second partition structure P2 can prevent crosstalk between sub-pixels of different colors.

For example, in some embodiments, in a direction perpendicular to the base substrate 110, the height H1 of the first partition structure P1 is different from the height H2 of the second partition structure P2. Thus, the first partition structure P1 and the second partition structure P2 achieve varying degrees of partition at different positions to fully and effectively partition the light-emitting material layer E2.

For example, in some embodiments, the height of the first partition structure P1 is less than the height of the second partition structure P2, thereby providing a more effective partitioning effect at the second partition structure P2.

For example, in some embodiments, as shown in Fig. 2, the pixel definition layer PDL includes a first pixel definition layer PDL1 and a second pixel definition layer PDL2 provided on a side of the first pixel definition layer PDL1 away from the base substrate 110. The first pixel definition layer PDL1 includes an inorganic material, and the second pixel definition layer PDL2 includes an organic material, such as polyimide, resin, or other organic insulating materials.

For example, in some embodiments, the first pixel definition layer PDL1 includes a multilayer structure. For example, as shown in Fig. 2, the first pixel definition layer PDL1 includes a first sub-pixel definition layer PDL11 and a second sub-pixel definition layer PDL12 provided on a side of the first sub-pixel definition layer PDL11 away from the base substrate 110. Materials of the first sub-pixel definition layer PDL11 and the second sub-pixel definition layer PDL12 are different. For example, during a manufacturing process, the materials of the first sub-pixel definition layer PDL11 and the second sub-pixel definition layer PDL12 has different etching rates relative to the etchant used, thus facilitating the formation of the partition structures.

For example, in a direction parallel to the base substrate 110, and at the plurality of first openings O1, the first sub-pixel definition layer PDL11 is recessed relative to the second sub-pixel definition layer PDL12, such that the first partition structure P1 includes a first undercut structure. That is, the area occupied by the first sub-pixel definition layer PDL11 at the bottom is smaller, while the area occupied by the second sub-pixel definition layer PDL12 at the top is larger. For example, the orthographic projection of the first sub-pixel definition layer PDL11 on the base substrate 110 is smaller than the orthographic projection of the second sub-pixel definition layer PDL12 on the base substrate 110. As a result, when the light-emitting material layer is formed above the second sub-pixel definition layer PDL12, the light-emitting material layer is easily disconnected at the first undercut structure.

For example, in some embodiments, as shown in Fig. 2, at the plurality of first openings O1, the first sub-pixel definition layer PDL11 is recessed relative to the second sub-pixel definition layer PDL12 by a distance of 0.05 µm to 0.2 µm, for example, 0.05 µm, 0.07 µm, 0.09 µm, 0.12 µm, 0.15 µm, 0.18 µm, or 0.20 µm, etc., to ensure that the first undercut structure of the first partition structure P1 has sufficient partitioning effect.

For example, as shown in Fig. 2, in the direction parallel to the base substrate 110, and at the plurality of second openings O2, the first sub-pixel definition layer PDL11 is recessed relative to the second sub-pixel definition layer PDL12, such that the second partition structure P2 includes a second undercut structure. Similar to the first undercut structure, at the plurality of second openings O2, the area occupied by the first sub-pixel definition layer PDL11 at the bottom is smaller, while the area occupied by the second sub-pixel definition layer PDL12 at the top is larger. For example, the orthographic projection of the first sub-pixel definition layer PDL11 on the base substrate 110 is smaller than the orthographic projection of the second sub-pixel definition layer PDL12 on the base substrate 110. As a result, when the light-emitting material layer is formed above the second sub-pixel definition layer PDL12, the light-emitting material layer is easily disconnected at the second undercut structure.

For example, at the plurality of second openings O2, the first sub-pixel definition layer PDL11 is recessed relative to the second sub-pixel definition layer PDL12 by a distance of 0.05 µm to 0.2 µm, for example, 0.05 µm, 0.07 µm, 0.09 µm, 0.12 µm, 0.15 µm, 0.18 µm, or 0.20 µm, etc.

For example, in some embodiments, a recessed distance L1 of the first sub-pixel definition layer PDL11 relative to the second sub-pixel definition layer PDL12 at the plurality of first openings O1 may be different from a recessed distance L2 of the first sub-pixel definition layer PDL11 relative to the second sub-pixel definition layer PDL12 at the plurality of second openings O2, to achieve varying degrees of partitioning effects. For example, in some examples, the recessed distance L2 is greater than the recessed distance L1 to form a stronger partitioning effect between adjacent sub-pixels SP, thereby preventing crosstalk between adjacent sub-pixels SP.

For example, in some embodiments, two materials selected from a group consisting of Al₂O₃, SiN, SiO, SiCN, TiO, and Nb₂O₅ are respectively used as the materials of the first sub-pixel definition layer PDL11 and the second sub-pixel definition layer PDL12, for example, materials with different etching rates relative to the same etchant may be chosen. In some examples, the first sub-pixel definition layer PDL11 may be made of SiN, while the second sub-pixel definition layer PDL12 may be made of SiO. In other examples, the first sub-pixel definition layer PDL11 may be made of Al₂O₃, while the second sub-pixel definition layer PDL12 may be made of SiO or SiN.

For example, in some embodiments, as shown in Fig. 2, in the direction perpendicular to the base substrate 110, that is, in the vertical direction in the figure, the thickness of the first sub-pixel definition layer PDL11 is greater than the thickness of the second sub-pixel definition layer PDL12, so as to form a sufficiently high undercut structure to achieve a sufficient and effective partitioning effect.

For example, in some examples, the thickness of the first sub-pixel definition layer PDL11 ranges from 25 nm to 50 nm, such as 25 nm, 30 nm, 35 nm, 40 nm, 45 nm, or 50 nm, while the thickness of the second sub-pixel definition layer PDL12 ranges from 20 nm to 25 nm, such as 20 nm, 21 nm, 22 nm, 23 nm, or 24 nm.

For example, in the direction perpendicular to the base substrate 110, the thickness of the second pixel definition layer PDL2 ranges from 0.8 µm to 1.5 µm, such as 0.9 µm, 1.0 µm, 1.1 µm, 1.2 µm, 1.3 µm, or 1.4 µm.

For example, in some embodiments, as shown in Fig. 2, the second pixel definition layer PDL2 has a first slope angle a at each of the plurality of first openings O1 and a second slope angle b at each of the plurality of second openings O2. The first slope angle a ranges from 30° to 70°, such as 35°, 40°, 45°, 50°, 55°, 60°, or 65°. The second slope angle b ranges from 30° to 70°, such as 35°, 40°, 45°, 50°, 55°, 60°, 65°, or 70°. The second pixel definition layer PDL2 is made of an organic material, which may be formed by coating or similar methods during preparation. The organic material has a certain flowability property, which facilitates the formation of the above-mentioned slope angles.

For example, in some embodiments, because the first slope angle a and the second slope angle b of the second pixel definition layer PDL2 located on the upper layer are gentler, when the second electrode layer E3 is formed thereon, it is difficult for the second electrode layer E3 to be disconnected at the first slope angle a and the second slope angle b. That is, it is difficult for the second electrode layer E3 to be disconnected at the plurality of first openings O1 and the plurality of second openings O2, thereby forming a continuous second electrode layer E3, for example, the second electrode layer E3 is formed over the entire surface. The continuously provided second electrode layer E3 has lower resistance and can provide a more balanced electrode voltage to each sub-pixel SP, thereby improving the display uniformity of the display substrate.

For example, in some embodiments, as shown in Fig. 2, the display substrate may further include a passivation layer PVX provided between the protective insulation layer PLN and the plurality of first electrodes E1. The passivation layer PVX includes a plurality of second vias PVX0, which respectively expose the plurality of first vias PLN1. The plurality of first electrodes E1 are electrically connected to the output terminals T of the plurality of pixel driving circuits D through the plurality of second vias PVX0 and the plurality of first vias PLN1. For example, the passivation layer PVX includes a plurality of third openings O3 that are respectively connected to the plurality of second openings O2. The orthographic projections of the plurality of third openings O3 on the base substrate 110 at least partially overlap with the orthographic projections of the plurality of second openings O2 on the base substrate 110. As a result, the passivation layer PVX also contributes to the formation of the second partition structure P2, and the arrangement of the plurality of third openings O3 in the passivation layer PVX increases the height of the second partition structure P2.

For example, as shown in Fig. 2, the plurality of second vias PVX0 are respectively formed within the plurality of first vias PLN1. In this case, the orthographic projections of the plurality of second vias PVX0 on the base substrate 110 are respectively located within the orthographic projections of the plurality of first vias PLN1 on the base substrate 110. As a result, the plurality of first vias PLN1 and the plurality of second vias PVX0 form nested via structures, facilitating effective connection between the plurality of first electrodes E1 and the output terminals T of the plurality of pixel driving circuits D.

For example, in some embodiments, as shown in Fig. 2, the passivation layer PVX includes a first passivation layer PVX1 and a second passivation layer PVX2 provided on a side of the first passivation layer PVX1 away from the base substrate 110. The first passivation layer PVX1 and the second passivation layer PVX2 are made of different materials, and the second passivation layer PVX2 includes the plurality of third openings O3.

For example, during a manufacturing process, the etching rates of the first passivation layer PVX1 and the second passivation layer PVX2 with respect to the same etchant are different. For example, the etching rate of the etchant for the second passivation layer PVX2 is higher than the etching rate of the etchant for the first passivation layer PVX1, thereby facilitating the formation of the plurality of third openings O3 in the second passivation layer PVX2.

For example, in some embodiments, the passivation layer PVX is made of an inorganic material such as SiO, SiN, or Al₂O₃. For example, in some example, the first passivation layer PVX1 may be made of SiO, while the second passivation layer PVX2 may be made of SiN. In other embodiments, the first passivation layer PVX1 may be made of Al₂O₃, while the second passivation layer PVX2 may be made of SiO or SiN.

For example, in the direction perpendicular to the base substrate 110, the thickness of the first passivation layer PVX1 is greater than the thickness of the second passivation layer PVX2. As a result, during the manufacturing process, the first passivation layer PVX1 can serve as an effective etch resist, facilitating the precise formation of the corresponding structures.

For example, in some examples, the thickness of the first passivation layer PVX1 ranges from 100 nm to 200 nm, such as 110 nm, 130 nm, 150 nm, 170 nm, 180 nm, or 190 nm. The thickness of the second passivation layer PVX2 ranges from 40 nm to 100 nm, such as 40 nm, 45 nm, 50 nm, 60 nm, 70 nm, 80 nm, or 90 nm.

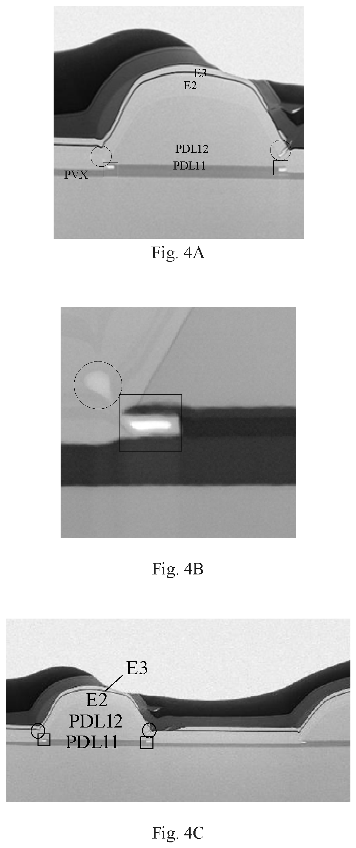

For example, Fig. 4A and Fig. 4B respectively illustrate transmission electron microscope images at the second partition structure P2. As shown in Fig. 4A, the position indicated by a box presents an undercut structure, and the position indicated by a circle presents a position where the light-emitting material layer E2 is disconnected. Fig. 4B shows the undercut structure on the left side of Fig. 4A and the position where the light-emitting material layer E2 is disconnected. As shown in Fig. 4A and Fig. 4B, on both sides of the second partition structure P2, the light-emitting material layer E2 is disconnected, while the second electrode layer E3 remains continuous. Therefore, the second partition structure P2 effectively achieves the partitioning effect for the light-emitting material layer E2 while maintaining the continuity of the second electrode layer E3. Fig. 4C illustrates a transmission electron microscope image at the first partition structure P1. As shown in Fig. 4C, the position indicated by a box presents an undercut structure, and the position indicated by a circle presents a position where the light-emitting material layer E2 is disconnected. As shown in Fig. 4C, on both sides of the first partition structure P1, the light-emitting material layer E2 is disconnected, while the second electrode layer E3 remains continuous. Therefore, the first partition structure P1 effectively achieves the partitioning effect for the light-emitting material layer E2 while maintaining the continuity of the second electrode layer E3.

By performing optical tests on the display substrate shown in Fig. 2, it can be concluded that the level of crosstalk is reduced for sub-pixels of different colors. For example, for red sub-pixels, the ratio of crosstalk light intensity to the light-emitting intensity of the sub-pixel (hereinafter referred to as the crosstalk rate) decreases from 6% (corresponding to a comparative embodiment without the first partition structure and the second partition structure) to 1.5%; for green sub-pixels, the ratio of crosstalk light intensity to the light-emitting intensity of the sub-pixel decreases from 8.5% (corresponding to a comparative embodiment without the first partition structure and the second partition structure) to 2%; and for blue sub-pixels, the ratio of crosstalk light intensity to the light-emitting intensity of the sub-pixel decreases from 8.5% (corresponding to a comparative embodiment without the first partition structure and the second partition structure) to 0% (with virtually no crosstalk light detected). Thus, the effectiveness of the first partition structure and the second partition structure in preventing crosstalk has been effectively verified.

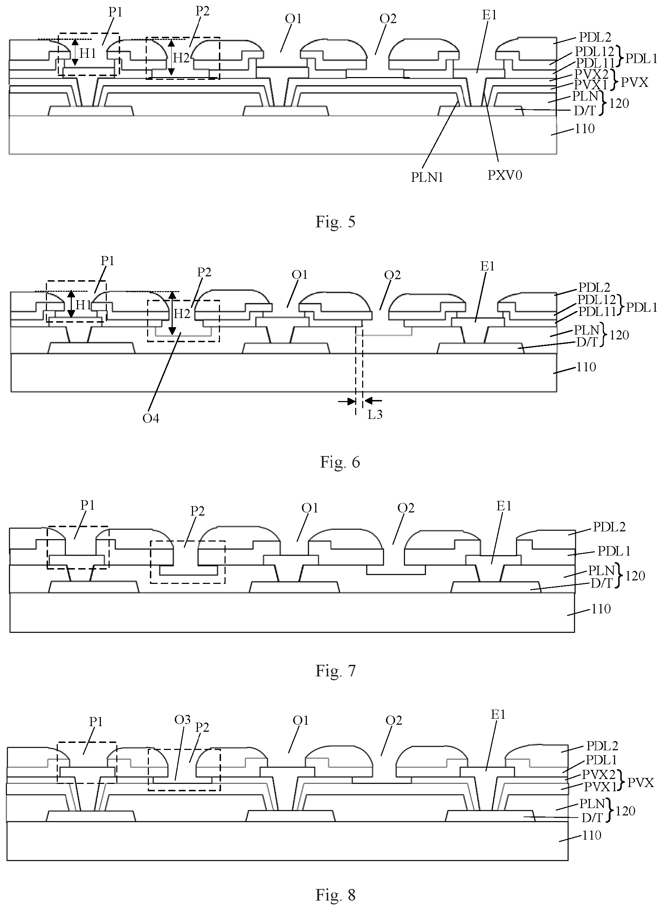

For example, in other embodiments, as illustrated in Fig. 5, even if the passivation layer PVX is provided, the passivation layer PVX may not be used to form the second partition structure P2, and instead, only the pixel definition layer PDL is used to form the second partition structure P2. This embodiment can also achieve the above-mentioned partitioning effect.

For example, in other embodiments, as shown in Fig. 6, the protective insulation layer PLN includes a plurality of fourth openings O4 that are respectively connected to the plurality of second openings O2, and the orthographic projections of the plurality of fourth openings O4 on the base substrate 110 at least partially overlap with the orthographic projections of the plurality of second openings O2 on the base substrate 110. As a result, the protective insulation layer PLN participates in forming the second partition structure, thereby increasing the height of the second partition structure.

For example, as shown in Fig. 6, in the direction parallel to the base substrate 110, the plurality of fourth openings O4 respectively extend outward relative to the plurality of second openings O2, such that the orthographic projections of the plurality of second openings O2 on the base substrate 110 are respectively located within the orthographic projections of the plurality of fourth openings O4 on the base substrate 110.

For example, as shown in Fig. 6, in the direction parallel to the base substrate 110, the plurality of fourth openings O4 extend outward relative to the plurality of second openings O2 by a distance L3 of 0.1 µm to 0.5 µm, such as 0.2 µm, 0.3 µm, 0.4 µm, or 0.5 µm, thereby forming a second undercut structure with a step-like cross-section.

Through testing, the display substrate shown in Fig. 6 can also effectively partition the light-emitting material layer E2 while still ensuring the continuity of the second electrode layer E3.

For example, in other embodiments, as shown in Fig. 7, the first pixel definition layer PDL1 may also have a single-layer structure. In this case, compared to the embodiment of Fig. 6, the structure of the first pixel definition layer PDL1 is slightly different, while the other structures remain essentially the same. The embodiment shown in Fig. 7 may be applied to white sub-pixels, that is, the plurality of sub-pixels SP are configured to emit white light. For example, through the use of color filters provided on the display substrate, full-color display can be achieved.

Through testing, the first partition structure P1 and the second partition structure P2 in this embodiment can reduce the crosstalk rate of sub-pixels to below 2%, and no crosstalk was detected in some sub-pixels.

For example, in other embodiments, as shown in Fig. 8, based on the embodiment of Fig. 7, the display substrate further includes a passivation layer PVX, which includes a first passivation layer PVX1 and a second passivation layer PVX2 on a side of the first passivation layer PVX1 away from the base substrate 110. The materials of the first passivation layer PVX1 and the second passivation layer PVX2 are different. The second passivation layer PVX2 includes a plurality of third openings O3, so that the second passivation layer PVX2 participates in forming the second partition structure P2, while the protective insulation layer PLN does not participate in forming the second partition structure P2.

For example, during a manufacturing process, the etching rates of the first passivation layer PVX1 and the second passivation layer PVX2 with respect to the same etchant are different. For example, the etching rate of the etchant for the second passivation layer PVX2 is greater than the etching rate of the etchant for the first passivation layer PVX1, which facilitates the formation of the plurality of third openings O3 in the second passivation layer PVX2.

Through testing, the first partition structure P1 and the second partition structure P2 in this embodiment can reduce the crosstalk rate of sub-pixels to below 2%, and no crosstalk was detected in some sub-pixels.

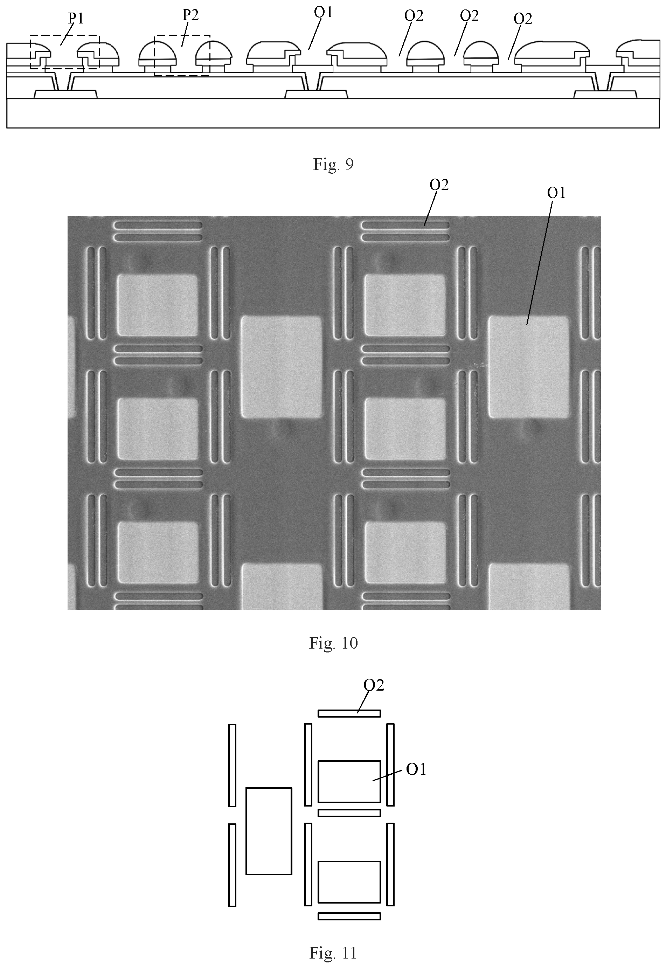

For example, in some embodiments, at least one second opening O2 is provided between every two adjacent sub-pixels SP among the plurality of sub-pixels SP. For example, in the embodiments shown in Fig. 2 and Fig. 5-Fig. 8, one second opening O2 is provided between adjacent sub-pixels SP, and correspondingly, one second partition structure P2 is provided. In the embodiment shown in Fig. 9, a plurality of second openings O2, such as three second openings O2, are shown between adjacent sub-pixels SP, and correspondingly, three second partition structures P2 are provided between adjacent sub-pixels SP.

For example, Fig. 10 illustrates a scanning electron microscope image of a display substrate provided by at least one embodiment of the present disclosure. This scanning electron microscope image shows a schematic arrangement of a plurality of first openings O1 and a plurality of second openings O2. As shown in Fig. 10, in this embodiment, two second openings O2 are provided between adjacent sub-pixels SP, and correspondingly, two second partition structures P2 are provided. The two second openings O2 are arranged side by side and parallel to each other, and each second opening O2 is provided on one side of the first opening O1. The second openings O2 located on different sides of the first opening O1 are not connected.

For example, in other embodiments, the number of second openings O2 and second partition structures P2 between adjacent sub-pixels SP may be other numbers, such as four, five, etc. The embodiments of the present disclosure are not specifically limited in this respect.

For example, Fig. 11 to Fig. 13 respectively illustrate different schematic arrangements of the plurality of first openings O1 and the plurality of second openings O2. In some embodiments, the plurality of second openings O2 are strip-shaped and spaced apart from each other. For example, the second openings O2 on different sides of the sub-pixel SP are strip-shaped and spaced apart from each other.

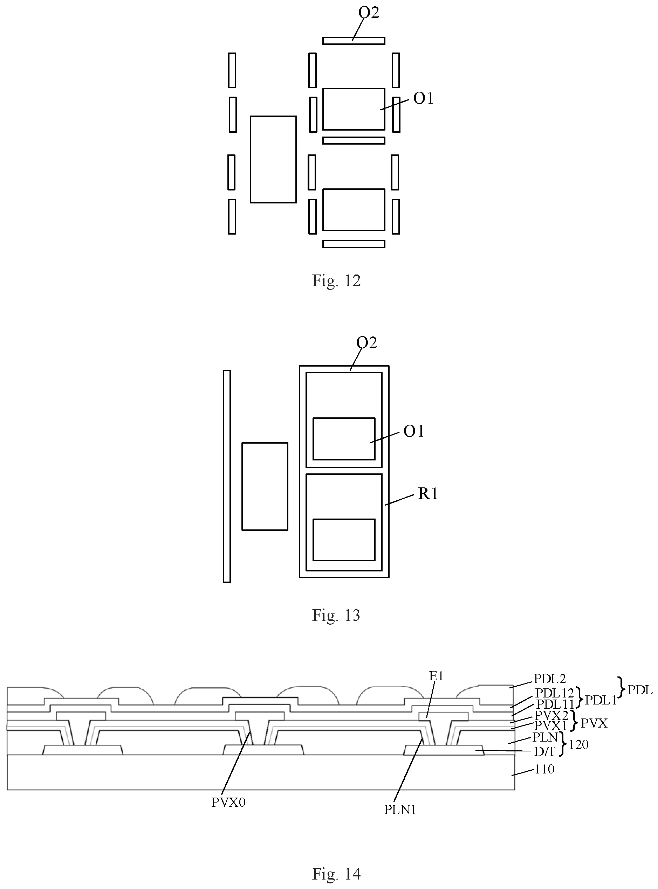

For example, as shown in Fig. 11, in some examples, one second opening O2 is provided between adjacent sub-pixels SP. The second opening O2 is strip-shaped, and the second openings O2 on different sides of the first opening O1 are not connected, i.e., spaced apart from each other. As shown in Fig. 12, in some examples, a plurality of second openings O2 are provided between adjacent sub-pixels SP. These second openings O2 are strip-shaped, and the plurality of second openings O2 on the same side of the sub-pixel SP extend along the same straight line. Each second opening O2 is on one side of the first opening O1, and the second openings O2 on different sides of the first opening O1 are not connected, i.e., spaced apart from each other.

For example, as shown in Fig. 13, in other examples, one second opening O2 is provided between adjacent sub-pixels SP. The second openings O2 on different sides of the first opening O1 are connected to form an annular opening R1 that completely surrounds at least one sub-pixel SP.

For example, corresponding to the embodiment of Fig. 13, at least some of the plurality of second openings O2 are interconnected to form an annular opening R1 that completely surrounds at least one sub-pixel SP, thereby sufficiently and effectively achieving the partitioning effect between adjacent sub-pixels SP.

For example, in other embodiments, corresponding to the embodiment of Fig. 10, a plurality of second openings O2 may also be provided between adjacent sub-pixels SP. The plurality of second openings O2 on different sides of the sub-pixels SP may be connected to form more annular openings that surround at least one sub-pixel SP, thereby further improving the partitioning effect between adjacent sub-pixels SP.

In summary, in the embodiments of the present disclosure, by providing the first partition structure and the second partition structure in the display substrate, and setting the heights of the first partition structure and the second partition structure to be different in some embodiments, the light-emitting material layer can be precisely partitioned. This avoids the continuity of light-emitting material layers of different sub-pixels, thereby addressing issues such as severe electrical crosstalk between sub-pixels and low color gamut. Additionally, by providing a multi-layer pixel definition layer structure, and utilizing advantage of the gentler slope angle of the organic material used in the second pixel definition layer at the top layer, phenomena such as partition-induced cathode piercing in the second electrode layer (i.e., the cathode) are prevented, which avoids the problem of increased cathode resistance.

At least one embodiment of the present disclosure further provides a method for manufacturing a display substrate. The display substrate has a plurality of sub-pixels SP arranged in an array. The method includes: providing a base substrate 110; forming a driving circuit layer 120 on the base substrate 110, in which the driving circuit layer 120 includes a plurality of pixel driving circuits D for the plurality of sub-pixels SP and a protective insulation layer PLN covering the plurality of pixel driving circuits D, and the protective insulation layer PLN includes a plurality of first vias PLN1 exposing output terminals T of the plurality of pixel driving circuits D; forming a plurality of first electrodes E1 on a side of the driving circuit layer 120 away from the base substrate 110, in which the plurality of first electrodes E1 are electrically connected to the output terminals T of the plurality of pixel driving circuits D through the plurality of first vias PLN1, respectively; and forming a pixel definition layer PDL at least on a side of the plurality of first electrodes E1 away from the base substrate 110, in which the pixel definition layer PDL includes a plurality of first openings O1 respectively exposing the plurality of first electrodes E1 and a plurality of second openings O2 provided between adjacent sub-pixels SP among the plurality of sub-pixels SP. The pixel definition layer PDL includes a first partition structure P1 at the plurality of first openings O1 and a second partition structure P2 at the plurality of second openings O2.

Below, with reference to Fig. 14 and Fig. 2, a detailed description of the method for manufacturing the display substrate as shown in Fig. 2 provided by the embodiments of the present disclosure is provided.

As shown in Fig. 14, first, a base substrate 110 is prepared. The base substrate 110 may be a rigid substrate such as a glass substrate or a flexible substrate such as a polyimide substrate. A driving circuit layer 120 is formed on the base substrate 110, for example, various structural layers of the driving circuit layer are sequentially formed on the base substrate 110 using patterning processes. For example, pixel driving circuits D are first formed, thereby forming a driving backplane such as an a-Si TFT substrate, an LTPS TFT substrate, or an Oxide TFT substrate.

A protective insulation layer PLN is formed on the pixel driving circuits D using a patterning process. For example, a protective insulation layer may be first formed on the pixel driving circuits D using a coating process or the like, a thickness of the protective insulation layer is, for example, about 1.5 µm to 2 µm. The protective insulation layer PLN is then patterned to form a protective insulation layer PLN with first vias PLN1. For example, one patterning process includes steps such as photoresist formation, exposure, development, etching, and the like, specific details may be found in related technologies.

A passivation layer PVX is then formed on the protective insulation layer PLN through deposition, sputtering, or other methods. The passivation layer PVX may be made of an inorganic material such as SiO, SiN, or Al₂O₃. For example, the passivation layer PVX may include a plurality of sub-layers, such as a first passivation layer PVX1 and a second passivation layer PVX2. The first passivation layer PVX1, which is at the bottom, may be made of SiO; and the second passivation layer PVX2, which is at the top, may be made of SiN. The formation thickness of the first passivation layer PVX1 ranges from 100 nm to 200 nm, and the formation thickness of the second passivation layer PVX2 ranges from 40 nm to 100 nm. For example, the passivation layer PVX is patterned to form the second vias PVX0.

A plurality of first electrodes E1 is formed on the passivation layer PVX using a patterning process, the first electrodes E1 may be served as anodes of light-emitting devices EM. For example, in the patterning process, a first electrode material layer is first formed on the passivation layer PVX through deposition, sputtering, or other methods; for example, three metal sub-layers of ITO/Ag/ITO are sequentially formed, in the direction away from the base substrate 110, the ITO layer, Ag layer, and ITO layer may be formed with thicknesses of 8 nm, 100 nm, and 8 nm respectively or 8 nm, 100 nm, and 12 nm respectively; then, the three metal sub-layers of ITO/Ag/ITO are patterned to form the plurality of first electrodes E1. Each of the first electrodes E1 is electrically connected to the output terminal T of a corresponding pixel driving circuit D through the second via PVX0 and first via PLN1.

Subsequently, a pixel definition layer PLD is formed on the plurality of first electrodes E1. The pixel definition layer PLD includes a first pixel definition layer PDL1 and a second pixel definition layer PDL2, the first pixel definition layer PDL1 is made of an inorganic material and the second pixel definition layer PDL2 is made of an organic material. For example, the first pixel definition layer PDL1 may include a plurality of sub-layers, such as a first sub-pixel definition layer PDL11 and a second sub-pixel definition layer PDL12. The first sub-pixel definition layer PDL11 and the second sub-pixel definition layer PDL12 may be formed of materials with relatively high etching selectivity such as Al₂O₃ and SiN/SiO or SiO and SiCN, or TiO and Nb₂O₅, etc. The embodiments of the present disclosure are not specifically limited to these materials. For example, in one embodiment, the first sub-pixel definition layer PDL11 is made of SiN, and the second sub-pixel definition layer PDL12 is made of SiO. The first sub-pixel definition layer PDL11 and the second sub-pixel definition layer PDL12 may be formed on the plurality of first electrodes E1 using a patterning process. The formation thickness of the first sub-pixel definition layer PDL11 may be about 25 nm to 50 nm, and the formation thickness of the second sub-pixel definition layer PDL12 may be about 20 nm to 25 nm.

For example, the second pixel definition layer PDL2 is made of a resin material such as polyimide and has a thickness of 0.8 µm to 1.5 µm. The second pixel definition layer PDL2 is then patterned using a patterning process to form the structure shown in Fig. 14.

Subsequently, the first pixel definition layer PDL1 is etched using the second pixel definition layer PDL2 as a mask, thereby forming a plurality of first openings O1 corresponding to the sub-pixels and a plurality of second openings O2 between adjacent sub-pixels. A first partition structure P1 is formed at the plurality of first openings O1, and a second partition structure P2 is formed at the plurality of second openings O2, as shown in Fig. 2.

For example, during the process of etching the first pixel definition layer PDL1, for the first partition structure P1, the etched layers are the first sub-pixel definition layer PDL11 and the second sub-pixel definition layer PDL12. The etch stop layer is the plurality of first electrodes E1. By adjusting the etchant to increase its etching selectivity for the first sub-pixel definition layer PDL11 and the second sub-pixel definition layer PDL12, the first sub-pixel definition layer PDL11 at bottom layer is etched more, while the second sub-pixel definition layer PDL12 at top layer is etched less, thus forming the first undercut structure of the first partition structure P1. For the second partition structure P2, at the second openings O2, the etched layers are the first sub-pixel definition layer PDL11, the second sub-pixel definition layer PDL12, and the second passivation layer PVX2 included in the passivation layer PVX. The first passivation layer PVX1 may be served as the etch stop layer. The etchant presents higher etching selectivity for the first passivation layer PVX1 and the second passivation layer PVX2, thereby forming the second partition structure P2 as shown in Fig. 2.

Subsequently, a light-emitting material layer E2 is formed on the pixel definition layer PDL using methods such as inkjet printing, and a second electrode layer E3 is formed using deposition, sputtering, or other methods. Afterward, the prepared substrate is subjected to an encapsulation process to complete the manufacture of the entire display substrate.

For the display substrate shown in Fig. 6, the manufacturing process may include the following steps.

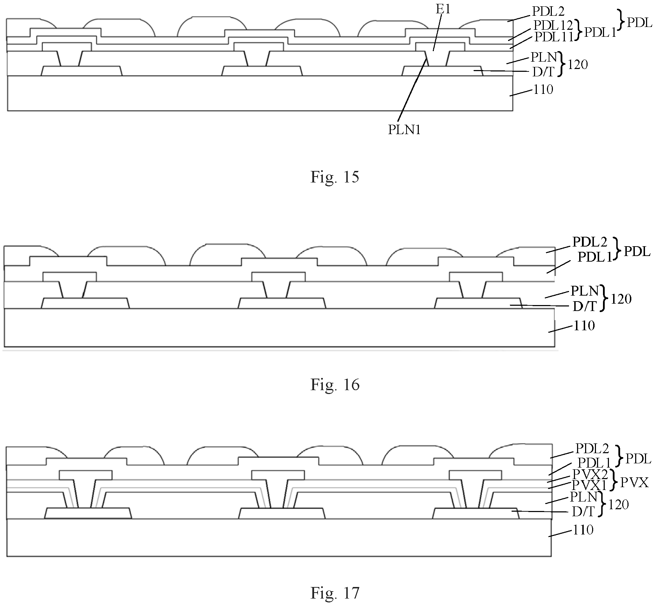

As shown in Fig. 15, first, a base substrate 110 is provided. The base substrate 110 may be a rigid substrate such as a glass substrate, or a flexible substrate such as polyimide. A driving circuit layer is formed on the base substrate 110, for example, various structural layers of the driving circuit layer are sequentially formed on the base substrate 110 using patterning processes. For example, the pixel driving circuits D are first formed, thereby forming a driving backplane such as an a-Si TFT substrate, an LTPS TFT substrate, or an Oxide TFT substrate.

A protective insulation layer PLN is formed on the pixel driving circuits D using a patterning process. For example, a protective insulation layer may be first formed on the pixel driving circuit D using a coating process, with a thickness, for example, of about 1.5 µm to 2 µm. The protective insulation layer PLN is then patterned to form a protective insulation layer PLN with first vias PLN1. For example, one patterning process includes steps such as photoresist formation, exposure, development, etching, and the like, specific details may be found in related technologies.

A plurality of first electrodes E1 are formed on the protective insulation layer PLN using a patterning process, the first electrodes E1 may be served as anodes of light-emitting devices EM. For example, in the patterning process, a first electrode material layer is first formed on the protective insulation layer PLN through deposition, sputtering, or other methods; for example, three metal sub-layers of ITO/Ag/ITO are sequentially formed, in the direction away from the base substrate 110, the ITO layer, Ag layer, and ITO layer may be formed with thicknesses of 8 nm, 100 nm, and 8 nm respectively or 8 nm, 100 nm, and 12 nm respectively; subsequently, the three metal sub-layers of ITO/Ag/ITO are patterned to form the plurality of first electrodes E1.

Subsequently, a pixel definition layer PLD is formed on the plurality of first electrodes E1. The pixel definition layer PLD includes a first pixel definition layer PDL1 and a second pixel definition layer PDL2, the first pixel definition layer PDL1 is made of an inorganic material and the second pixel definition layer PDL2 is made of an organic material. For example, the first pixel definition layer PDL1 may include a plurality of sub-layers, such as a first sub-pixel definition layer PDL11 and a second sub-pixel definition layer PDL12. The first sub-pixel definition layer PDL11 and the second sub-pixel definition layer PDL12 may be formed of materials with relatively high etching selectivity such as Al₂O₃ and SiN/SiO or SiO and SiCN, or TiO and Nb₂O₅, etc. The embodiments of the present disclosure are not specifically limited to these materials. For example, in one embodiment, the first sub-pixel definition layer PDL11 is made of SiN, and the second sub-pixel definition layer PDL12 is made of SiO. The first sub-pixel definition layer PDL11 and the second sub-pixel definition layer PDL12 may be formed on the plurality of first electrodes E1 using a patterning process. The formation thickness of the first sub-pixel definition layer PDL11 may be about 25 nm to 50 nm, and the formation thickness of the second sub-pixel definition layer PDL12 may be about 20 nm to 25 nm.

For example, the second pixel definition layer PDL2 is made of a resin material such as polyimide and has a thickness of 0.8 µm to 1.5 µm. The second pixel definition layer PDL2 is then patterned using a patterning process to form the structure shown in Fig. 15.

Subsequently, the first pixel definition layer PDL1 is etched using the second pixel definition layer PDL2 as a mask, thereby forming a plurality of first openings O1 corresponding to the sub-pixels and a plurality of second openings O2 between adjacent sub-pixels. A first partition structure P1 is formed at the plurality of first openings O1, and second partition structure P2 is formed at the plurality of second openings O2.

For example, during the process of etching the first pixel definition layer PDL1, for the first partition structure P1, the etched layers are the first sub-pixel definition layer PDL11 and the second sub-pixel definition layer PDL12. The etch stop layer is the plurality of first electrodes E1. By adjusting the etchant to increase its etching selectivity for the first sub-pixel definition layer PDL11 and the second sub-pixel definition layer PDL12, the first sub-pixel definition layer PDL11 at bottom layer is etched more, while the second sub-pixel definition layer PDL12 at top layer is etched less, thus forming the first undercut structure of the first partition structure P1. For the second partition structure P2, at the second openings O2, the etched layers are the first sub-pixel definition layer PDL11, the second sub-pixel definition layer PDL12, and part of the protective insulation layer PLN. For example, the etch depth may be 40 nm to 100 nm, thereby forming the second partition structure P2 as shown in Fig. 6.

Subsequently, a light-emitting material layer E2 is formed on the pixel definition layer PDL using methods such as inkjet printing, and a second electrode layer E3 is formed using deposition, sputtering, or other methods. Afterward, the prepared substrate is subjected to an encapsulation process to complete the manufacture of the entire display substrate.

For example, corresponding to the embodiment shown in Fig. 7, the difference in the manufacturing process compared to the embodiment in Fig. 6 is that the first pixel definition layer PDL1 is replaced with a single-layer inorganic material. As shown in Fig. 16, during the manufacturing process, the first pixel definition layer PDL1 includes only a single-layer structure. When subsequently forming the partition structures, the second pixel definition layer PDL2 is still used as a mask to etch the first pixel definition layer PDL1, to form a plurality of first openings O1 corresponding to the sub-pixels and a plurality of second openings O2 between adjacent sub-pixels, in which a first partition structure P1 is formed at the plurality of first openings O1, and a second partition structure P2 is formed at the plurality of second openings O2.

For example, during the etching process of the first pixel definition layer PDL1, the etched layer for the first partition structure P1 is the first pixel definition layer PDL1, and the etch stop layer is the plurality of first electrodes E1. For the second partition structure P2, the etched layers at the second opening O2 are the first pixel definition layer PDL1 and the protective insulation layer PLN, thereby forming the second partition structure P2, as shown in Fig. 7.

For example, corresponding to the embodiment shown in Fig. 8, the manufacturing process differs from that in Fig. 7 is the manufacturing of a passivation layer PVX. The passivation layer PVX includes a first passivation layer PVX1 and a second passivation layer PVX2. The first passivation layer PVX1 and the second passivation layer PVX2 are made of two materials with different etching rates for the same etchant. For example, the first passivation layer PVX1 at the bottom layer may be made of SiO, while the second passivation layer PVX2 at the top layer may be made of SiN. Subsequently, during the etching process, the first pixel definition layer PDL1 is etched using the second pixel definition layer PDL2 as a mask to form a plurality of first openings O1 corresponding to the sub-pixels and a plurality of second openings O2 between adjacent sub-pixels, in which a first partition structure P1 is formed at the plurality of first openings O1, and a second partition structure P2 is formed at the plurality of second openings O2.

For example, during the process of etching the first pixel definition layer PDL1, the etched layer for the first partition structure P1 is the first pixel definition layer PDL1, with the etch stop layer being the plurality of first electrodes E1. For the second partition structure P2, the etched layers at the second opening O2 are the first pixel definition layer PDL1 and the second passivation layer PVX2, with the etch stop layer being the first passivation layer PVX1, thereby forming the second partition structure P2, as shown in Fig. 8.

For example, the manufacturing process for other structures on the display substrate may refer to related techniques. The embodiments of the present disclosure are not specifically limited in this aspect.

The following statements should be noted:
(1) The drawings involve only the structure(s) in connection with the embodiment(s) of the present disclosure, and other structure(s) can be referred to common design(s).
(2) For clarity, in the drawings used to describe the embodiments of the present disclosure, the thicknesses of layers or regions are enlarged or reduced, that is, the drawings are not drawn to actual scale. It can be understood that when a component such as a layer, film, region or substrate is referred to as being "on" or "under" another component, the component may be "directly" "on" or "under" another component, or one or more intermediate components may be interposed therebetween.
(3) In case of no conflict, features in one embodiment or in different embodiments can be combined to obtain new embodiments.

What have been described above are only specific implementations of the present disclosure, the protection scope of the present disclosure is not limited thereto, and the protection scope of the present disclosure should be based on the protection scope of the claims.

## Claims

1. A display substrate, having a plurality of sub-pixels arranged in an array, and comprising:
a base substrate;
a driving circuit layer, provided on the base substrate, comprising a plurality of pixel driving circuits for the plurality of sub-pixels and a protective insulation layer covering the plurality of pixel driving circuits, wherein the protective insulation layer comprises a plurality of first vias exposing output terminals of the plurality of pixel driving circuits;
a plurality of first electrodes, provided on a side of the driving circuit layer away from the base substrate, and electrically connected to the output terminals of the plurality of pixel driving circuits through the plurality of first vias, respectively; and
a pixel definition layer, at least provided on a side of the plurality of first electrodes away from the base substrate, comprising a plurality of first openings respectively exposing the plurality of first electrodes and a plurality of second openings provided between adjacent sub-pixels among the plurality of sub-pixels,
wherein the pixel definition layer comprises a first partition structure at the plurality of first openings and a second partition structure at the plurality of second openings.

2. The display substrate according to claim 1, wherein in a direction perpendicular to the base substrate, a height of the first partition structure is different from a height of the second partition structure.

3. The display substrate according to claim 2, wherein the height of the first partition structure is less than the height of the second partition structure.

4. The display substrate according to any one of claims 1 to 3, wherein the pixel definition layer comprises a first pixel definition layer and a second pixel definition layer provided on a side of the first pixel definition layer away from the base substrate; and
the first pixel definition layer comprises an inorganic material, and the second pixel definition layer comprises an organic material.

5. The display substrate according to claim 4, wherein the organic material comprises polyimide or resin.

6. The display substrate according to claim 4, wherein the first pixel definition layer comprises a first sub-pixel definition layer and a second sub-pixel definition layer provided on a side of the first sub-pixel definition layer away from the base substrate, and a material of the first sub-pixel definition layer is different from a material of the second sub-pixel definition layer; and
in a direction parallel to the base substrate, and at the plurality of first openings, the first sub-pixel definition layer is recessed relative to the second sub-pixel definition layer, such that the first partition structure comprises a first undercut structure.

7. The display substrate according to claim 6, wherein at the plurality of first openings, the first sub-pixel definition layer is recessed relative to the second sub-pixel definition layer by a distance of 0.05 µm to 0.2 µm.

8. The display substrate according to claim 4, wherein the first pixel definition layer comprises a first sub-pixel definition layer and a second sub-pixel definition layer provided on a side of the first sub-pixel definition layer away from the base substrate, and a material of the first sub-pixel definition layer is different from a material of the second sub-pixel definition layer; and
in a direction parallel to the base substrate, and at the plurality of second openings, the first sub-pixel definition layer is recessed relative to the second sub-pixel definition layer, such that the second partition structure comprises a second undercut structure.

9. The display substrate according to claim 8, wherein at the plurality of second openings, the first sub-pixel definition layer is recessed relative to the second sub-pixel definition layer by a distance of 0.05 µm to 0.2 µm.

10. The display substrate according to any one of claims 6 to 9, wherein two materials selected from a group consisting of Al₂O₃, SiN, SiO, SiCN, TiO, and Nb₂O₅ are respectively materials of the first sub-pixel definition layer and the second sub-pixel definition layer.

11. The display substrate according to any one of claims 6 to 10, wherein in a direction perpendicular to the base substrate, a thickness of the first sub-pixel definition layer is greater than a thickness of the second sub-pixel definition layer.

12. The display substrate according to claim 11, wherein the thickness of the first sub-pixel definition layer ranges from 25 nm to 50 nm, and the thickness of the second sub-pixel definition layer ranges from 20 nm to 25 nm.

13. The display substrate according to any one of claims 4 to 12, wherein in a direction perpendicular to the base substrate, a thickness of the second pixel definition layer ranges from 0.8 µm to 1.5 µm.

14. The display substrate according to any one of claims 4 to 13, wherein the second pixel definition layer comprises a first slope angle at each of the plurality of first openings and a second slope angle at each of the plurality of second openings; and
the first slope angle ranges from 30° to 70°, and the second slope angle ranges from 30° to 70°.

15. The display substrate according to any one of claims 1 to 14, further comprising a passivation layer provided between the protective insulation layer and the plurality of first electrodes, wherein the passivation layer comprises a plurality of second vias respectively exposing the plurality of first vias, and the plurality of first electrodes are electrically connected to the output terminals of the plurality of pixel driving circuits through the plurality of second vias and the plurality of first vias; and
the passivation layer comprises a plurality of third openings respectively connected to the plurality of second openings, and orthographic projections of the plurality of third openings on the base substrate at least partially overlap with orthographic projections of the plurality of second openings on the base substrate.

16. The display substrate according to claim 15, wherein orthographic projections of the plurality of second vias on the base substrate are respectively located within orthographic projections of the plurality of first vias on the base substrate.

17. The display substrate according to claim 15, wherein the passivation layer comprises a first passivation layer and a second passivation layer provided on a side of the first passivation layer away from the base substrate; and
materials of the first passivation layer and the second passivation layer are different, and the second passivation layer comprises the plurality of third openings.

18. The display substrate according to claim 17, wherein in a direction perpendicular to the base substrate, a thickness of the first passivation layer is greater than a thickness of the second passivation layer.

19. The display substrate according to claim 18, wherein the thickness of the first passivation layer ranges 100 nm to 200 nm, and the thickness of the second passivation layer ranges 40 nm to 100 nm.

20. The display substrate according to any one of claims 1 to 13, wherein the protective insulation layer comprises a plurality of fourth openings respectively connected to the plurality of second openings, and orthographic projections of the plurality of fourth openings on the base substrate at least partially overlap with orthographic projections of the plurality of second openings on the base substrate.

21. The display substrate according to claim 20, wherein in a direction parallel to the base substrate, the plurality of fourth openings respectively extend outward relative to the plurality of second openings, such that the orthographic projections of the plurality of second openings on the base substrate are respectively located within the orthographic projections of the plurality of fourth openings on the base substrate.

22. The display substrate according to claim 21, wherein in the direction parallel to the base substrate, the plurality of fourth openings extend outward relative to the plurality of second openings by a distance of 0.1 µm to 0.5 µm.

23. The display substrate according to any one of claims 1 to 22, wherein at least one second opening is provided between every two adjacent sub-pixels among the plurality of sub-pixels.

24. The display substrate according to any one of claims 1 to 23, wherein at least part of the plurality of second openings are interconnected to form an annular opening that completely surrounds at least one of the plurality of sub-pixels.

25. The display substrate according to any one of claims 1 to 23, wherein the plurality of second openings are respectively strip-shaped and spaced apart from each other.

26. The display substrate according to any one of claims 1 to 25, further comprising:
a light-emitting material layer, provided on a side of the pixel definition layer away from the base substrate; and
a second electrode layer, provided on a side of the light-emitting material layer away from the base substrate,
wherein at least part of the light-emitting material layer is disconnected by at least one of the first partition structure and the second partition structure, and the second electrode layer is continuous at at least one of the first partition structure and the second partition structure.

27. The display substrate according to claim 26, wherein the light-emitting material layer comprises at least one charge generation layer, and the at least one charge generation layer is disconnected by at least one of the first partition structure and the second partition structure.

28. A method for manufacturing a display substrate, wherein the display substrate has a plurality of sub-pixels arranged in an array, and the method comprises:
providing a base substrate;
forming a driving circuit layer on the base substrate, wherein the driving circuit layer comprises a plurality of pixel driving circuits for the plurality of sub-pixels and a protective insulation layer covering the plurality of pixel driving circuits, and the protective insulation layer comprises a plurality of first vias exposing output terminals of the plurality of pixel driving circuits;
forming a plurality of first electrodes on a side of the driving circuit layer away from the base substrate, wherein the plurality of first electrodes are electrically connected to the output terminals of the plurality of pixel driving circuits through the plurality of first vias, respectively; and
forming a pixel definition layer at least on a side of the plurality of first electrodes away from the base substrate, wherein the pixel definition layer comprises a plurality of first openings respectively exposing the plurality of first electrodes and a plurality of second openings provided between adjacent sub-pixels among the plurality of sub-pixels,
and the pixel definition layer comprises a first partition structure formed at the plurality of first openings and a second partition structure formed at the plurality of second openings.
